# EUROPÄISCHE PATENTANMELDUNG

(11) **EP 0 824 051 A1**
(43) Veröffentlichungstag der Anmeldung: **18.02.1998**
(21) Anmeldenummer: 97111992.0
(22) Anmeldetag: 15.07.1997
(51) Int. Cl.: B23K 3/08

(54) **Verfahren und Vorrichtung zur mechanischen Beseitigung von Lotkugeln auf der Oberfläche von Leiterplatten**

(30) Priorität: 10.08.1996 DE 19632335
(71) Anmelder: MESSER GRIESHEIM GMBH, 60547 Frankfurt (DE)
(72) Erfinder: Tauchmann, Jens, 13189 Berlin (DE); Schwinn, Tilman, Dr., 47800 Krefeld (DE); Lucht, Heinz-Olaf, 47804 Krefeld (DE)

(57) **Zusammenfassung**

Die Erfindung betrifft ein Verfahren zur mechanischen Beseitigung von Lotkugeln (14) von der Oberfläche von Leiterplatten (10) unmittelbar nach Durchlaufen der Lotwelle beim Wellenlöten von Leiterplatten in einer Lötanlage. Um eine mechanische Beseitigung der Lotkugeln ohne Beschädigung der Leiterplatten sicherzustellen, werden die Lotkugeln 14 durch mindestens einen auf die Oberfläche gerichteten kalten Gasstrahl (50) mechanisch beseitigt.

## Beschreibung

Die Erfindung betrifft ein Verfahren und eine Vorrichtung zur mechanischen Beseitigung von Lotkugeln auf der Oberfläche von Leiterplatten nach dem Oberbegriff der Ansprüche 1 und 12 sowie einen Kaltgasmischer zum Bereitstellen eines kalten Gasstromes für die mechanische Beseitigung von Lotkugeln auf der Oberfläche von Leiterplatten nach dem Oberbegriff des Anspruches 17.

Beim Wellenlöten von Leiterplatten entstehen aufgrund verschiedener physikalischer Effekte sogenannte Lotkugeln. Diese können bei elektronischen Geräten zu erheblichen Funktionsstörungen führen. Derartige Lotkugeln wurden früher durch einen Waschvorgang unter Verwendung von Fluorkohlenwasserstoffen (FCKW's) beseitigt. Da aus Umweltschutzgründen der Einsatz von FCKW nicht mehr ohne massive Einschränkungen möglich ist, werden umweltverträgliche Verfahren eingesetzt.

Man versucht daher, durch die Verwendung modifizierter Lötstoplacke mit abhäsiven Eigenschaften die Ausbildung von Lotkugeln von vorn herein zu verhindern. Weil der Lötstoplack aber auch adhäsiv auf den Leiterbahnen haften muß, kann die Adhäsion von Lot auf diese Weise nicht vollständig verhindert werden.

Es wurde daher in der DE-A 44 16 788 bereits vorgeschlagen, durch eine zusätzliche künstliche Abkühlung mit einem Gasstrom die Haftung von Lotkügelchen auf der Oberfläche der Leiterplatten zu verhindern. Dabei soll durch einen höchstens Raumtemperatur aufweisenden Gasstrom eine thermomechanische Fehlanpassung zwischen Lötstopmaske und Lot erzeugt werden, damit ein Anhaften der Lotkügelchen erst gar nicht stattfinden kann.

Neben diesen Maßnahmen zur Vermeidung von anhaftenden Lotkugeln auf der Oberfläche der Leiterplatten sind Bürsteinrichtungen bekannt, mittels denen die Lotkugeln mechanisch beseitigt werden. Es kann dabei aber nicht ausgeschlossen werden, daß auf der Oberfläche der Leiterplatte vorhandene SMD-Bauteile (Surface Mounted Devices), sowie Bauteile mit Anschlußdrähten oder die Leiterplatte als ganzes beschädigt werden.

Der Erfindung liegt die Aufgabe zugrunde, ein Verfahren und eine Vorrichtung zur mechanischen Beseitigung von Lotkugeln auf der Oberfläche von Leiterplatten zu schaffen, mit dem sich anhaftende Lotkugeln ohne Beschädigung der Leiterplatten entfernen lassen.

Ausgehend von dem im Oberbegriff genannten Stand der Technik ist diese Aufgabe erfindungsgemäß gelöst, mit den in den Ansprüchen 1 und 12 angegebenen Merkmalen.

Weiterbildungen der Erfindung sind in den Unteransprüchen angegeben.

Bei dem erfindungsgemäßen Verfahren wird die mechanische Beseitigung der Lotkugeln während der Zerstörung der zwischen Lötstoplack und Lot gebildeten Adhäsionsflächen durchgeführt; dabei erfolgt die Abkühlung der Oberfläche der Leiterplatten und die mechanische Beseitigung der Lotkugeln durch einen kalten Gasstrahl gleichzeitig. Durch die Formung eines kalten Gasstrahles wird an der Oberfläche der Leiterplatte ein hoher Abblasedruck gebildet, der die Lotkugeln von der Oberfläche der Leiterplatten entfernt.

Eine besonders gute mechanische Beseitigung der Lotkugeln läßt sich mit dem erfindungsgemäßen Verfahren dann erzielen, wenn der Gasstrahl mit einer Temperatur zwischen -20 °C und -60 °C unter einem Anblaswinkel < 45°, vorzugsweise unter einem Anblaswinkel zwischen 30° und 40°, gemessen zwischen der Leiterplatte und der Austrittsöffnung der Düse, die Oberfläche der Leiterplatten beaufschlagt. Durch die Einstell- und Temperaturparameter läßt sich eine nahezu vollständige Entfernung der Lotkugeln sicherstellen.

Besonders gute Arbeitsergebnisse lassen sich dann erzielen, wenn die Lotkugeln nach dem Erstarren von dem Gasstrahl beaufschlagt werden. Unter Erstarren wird hierbei eine Abkühlung der Lotkugeln bis zu einer nicht mehr flüssigen Konsistenz verstanden. Durch die mechanische Beseitigung der Lotkugeln nach dem Erstarren wird ein Versprühen durch den mit hohem Abblasedruck auftreffenden kalten Gasstrahl vermieden.

Bevorzugt wird mindestens eine Seite der Oberfläche der Leiterplatte über die gesamte Breite mit vielen kalten Gasstrahlen beaufschlagt, die durch Vereinzelung aus einem kalten Gasstrom jeweils erzeugt werden. Dabei wird die Oberfläche der Leiterplatten vorzugsweise in der Förderrichtung der Leiterplatten über die gesamte Breite mit einer angepaßten Anzahl von Gasstrahlen beaufschlagt. Durch die in Förderrichtung der Leiterplatten aus Düsen austretenden Gasstrahlen kann auf eine Bewegung der Düsen verzichtet werden. Es ist selbstverständlich auch möglich, die Düsen seitlich zum Förderweg der Leiterplatten anzuordnen und die Düsen senkrecht zum Förderweg der Leiterplatten zu verfahren. Durch die Anordnung mehrerer in Förderrichtung der Leiterplatten hintereinander angeordnete Düsenreihen lassen sich über die gesamte Breite einer Seite der Oberfläche der Leiterplatten vorhangartige Gasstrahlenreihen ausbilden, die je nach Kältebedarf für die thermomechanische Fehlanpassung und die mechanische Entfernung der Lotkugeln zu- und abgeschaltet werden.

Besonders vorteilhaft wird der für die Ausbildung der Gasstrahlen erzeugte kalte Gasstrom aus einem Inertgas gebildet, wodurch die Oxidation der Lötstellen behindert und die Oberflächenspannung des Lotes erhöht wird. Als Inertgas werden Stickstoff, Argon, Kohlendioxid oder Gasmischungen daraus eingesetzt. Die Temperatur des kalten Gas-stromes wird aus der gasförmigen und flüssigen Phase des eingesetzten Gases oder Gasgemisches gebildet. Die Mischung des tiefkalt verflüssigten und gasförmigen Gases oder Gasgemisches erfolgt so, daß vor der Mischung die Masse der Flüssigkeit geringer als die des Gases ist. Durch die erfindungsgemäße Bildung eines kalten Gasstromes durch Vermischen der gasförmigen und flüssigen Phase des eingesetzten Gases oder Gasgemisches kann vorteilhaft mit geringem Aufwand ein begrenzter Bereich der Oberfläche der Leiterplatten mit einem Gasstrahl beaufschlagt werden, der auf Temperaturen zwischen -20 °C und -60 °C abgekühlt ist.

Durch die Formung des Gasstromes zu Gasstrahlen in Lavalkanälen der Düsen werden hohe Austrittsgeschwindigkeiten aus den Düsen erzielt, mittels denen sich ein hoher Abblasedruck bei geringem Gasdurchsatz an der Oberfläche der Leiterbahnen erreichen läßt.

Besonders gute wirtschaftliche Ergebnisse lassen sich mit dem erfindungsgemäßen Verfahren dann erzielen, wenn der kalte Gasstrom diskontinuierlich in Abhängigkeit von einem Signal erzeugt wird, daß beim Durchlaufen der Leiterplatten in der Lötanlage gebildet wird. Das Signal kann hierbei zum Beispiel beim Eintritt der Leiterplatten in die Lötanlage erzeugt werden; es kann jedoch auch an einer anderen Stelle der Lötanlage gebildet und zum Starten der Gasstrahlen verwendet werden. Um den bevorzugten Temperaturbereich zwischen -20 °C und -60 °C vorzugsweise -25 °C bis -45 °C an der Oberfläche der Leiterplatten zu erzielen wird die Temperatur des kalten Gasstromes in Abhängigkeit von der Vorlaufstrecke der Leiterplatte bis zum Erreichen der Gasstrahlen und/oder der Ist-Temperatur des Gasstromes eingestellt. Dabei wird die Abkühlung in mehreren Phasen mit unterschiedlichen Temperaturwerten durchgeführt. Die Vorrichtung zur mechanischen Beseitigung von Lötkugeln wird nach einem Steuerzyklus kalt gefahren und nach einem anderen Steuerzyklus wird die Temperatur der Leiterplatte und des Gasstromes zum Beaufschlagungszeitpunkt mittels der Gas-strahlen berücksichtigt.

Durch eine Vorrichtung gemäß dem Anspruch 12 lassen sich in einfacher Weise kalte Gasstrahlen erzeugen und auf die Oberfläche der Leiterplatten richten. Durch die Ausbildung der Düse als Lavaldüse lassen sich hohe Abblasedrücke für die mechanische Entfernung der Lotkugeln erzeugen.

Durch die Merkmale der Ansprüche 18, 19 und 20 läßt sich mit geringem Aufwand ein kalter Gasstrom erzeugen, dessen Temperatur in einfacher Weise an die Lötbedingungen und die Lötanlagen angepaßt werden kann.

Ein Ausführungsbeispiel der Erfindung ist in der Zeichnung dargestellt und wird im folgenden näher beschrieben.

Es zeigen
- Figur 1: eine schematische Seitenansicht eines Ausschnittes einer Leiterplatte;
- Figur 2: eine schematische Darstellung der Vorrichtung zum Erzeugen von kalten Gasstrahlen;
- Figur 3: eine schematische Darstellung des in Figur 2 dargestellten Kaltgasmischers im Schnitt.

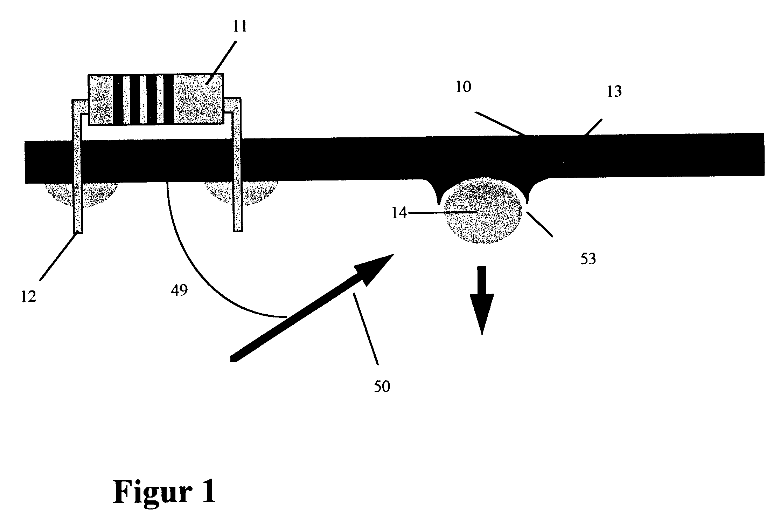

In Figur 1 ist eine Leiterplatte 10 mit Bauteilen 11 mit Anschlußdrähten 12 schematisch dargestellt, die in einer nicht näher dargestellten Lötanlage nach einem in der DE-A 44 16 788 beschriebenen Wellenlötverfahren bearbeitet werden. Die auf einem Transportrahmen angeordneten Leiterplatten 10 werden mit einer Transporteinrichtung in Transportrichtung 15 zu einer Benetzungseinrichtung gefördert, in der Flußmittel auf die untere Lötoberseite der Leiterplatte 10 aufgebracht wird.

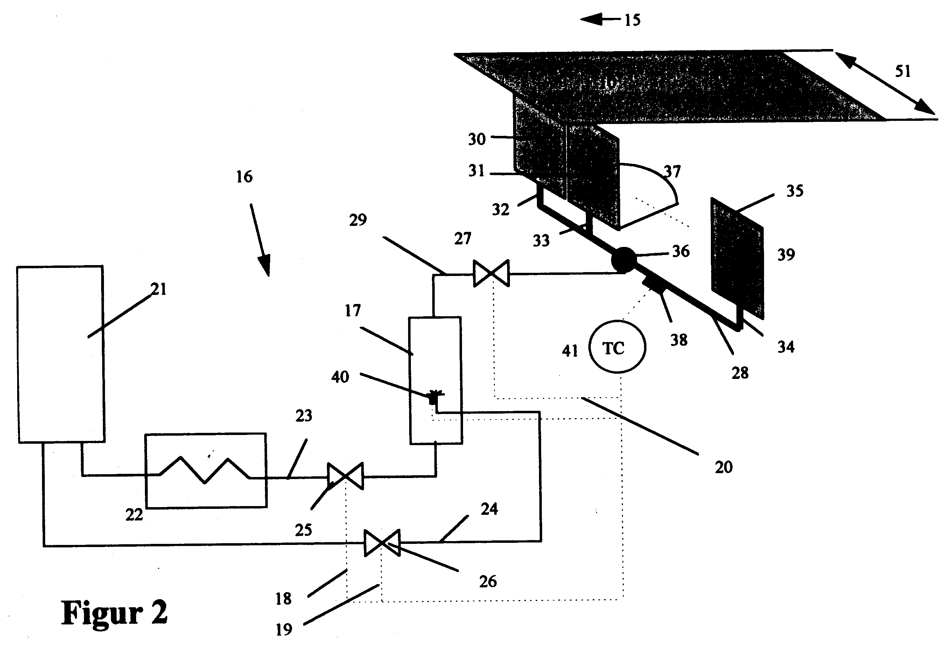

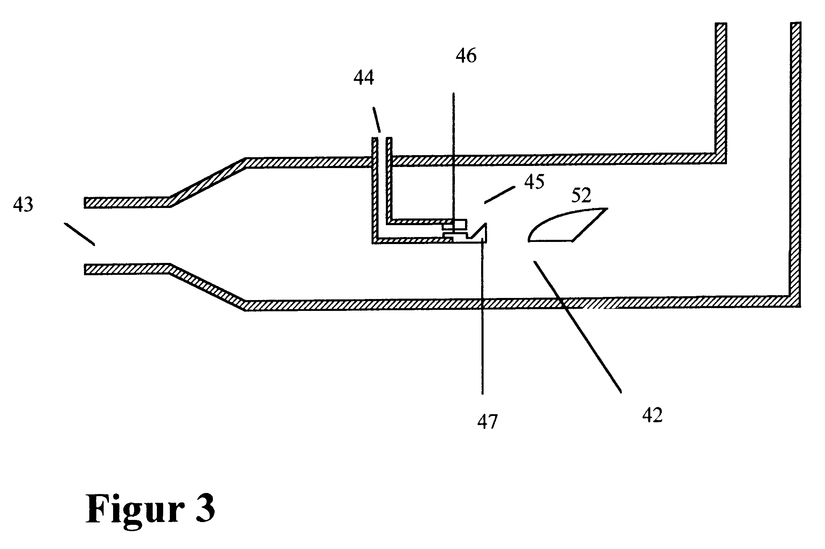

Nachdem der Transportrahmen mit der zu lötenden Leiterplatte 10 über die Benetzungseinrichtung hinweggelaufen ist, gelangt er in den Bereich einer Wellenlöteinrichtung. Dabei ist die Transporteinrichtung bezüglich der Lotwelle so ausgerichtet, daß die zu lötende Leiterplatte 10 die Lotwelle durchläuft, wodurch das Löten erfolgt. Beim Löten wird die Lotwelle in ihrem Strömungsverhalten durch die Bauteile bzw. die Anschlußdrähte 12 gestört. Dies führt zum Separieren des Lotes, das in der Lötatmosphäre eine Zinn-Blei-Mischoxidoberfläche ausbildet. Diese oxidierten Lötvolumina werden auf dem Lötstoplack 13 der Leiterplatten 10 als Lotkügelchen 14 adhäsiv fixiert. In Transportrichtung 15 der Leiterplatte 10 ist hinter der Lötvorrichtung eine Kaltgasstrahleinrichtung 16 zur mechanischen Beseitigung der Lotkugeln 14 vorgesehen. Die in den Figuren 2 und 3 nur schematisch dargestellte Kaltgasstrahleinrichtung 16 besteht im wesentlichen aus einem Kaltgasmischer 17 der eingangsseitig über zwei Leitungen 23, 24 mit einem kälteisolierten Tank 21 für tiefkalt verflüssigte Gase oder Gasgemische verbunden ist. In der Leitung 23 ist ein Luftverdampfer 22 angeordnet, in dem das aus dem Tank 21 zum Kaltgasmischer 17 geförderte tiefkalt verflüssigte Gas verdampft wird. Zwischen dem Luftverdampfer 22 und dem Kaltgasmischer ist in der Leitung 23 und in der Leitung 24 ein über Steuerleitungen 18, 19 ansteuerbare Einstellmittel 25, 26, beispielsweise Dosierventile, angeordnet. Über die Dosierventile können die in Leitung 23 nach dem Luftverdampfer vorhandenen Gase und die in Leitung 24 vom Tank 21 geförderten Flüssiggasmengen gesteuert oder geregelt werden. Dabei können dem Kaltgasmischer 17 differierende Gas- und Flüssiggasmengen zugeführt werden. Über die Einstellung des Mischungsverhältnisses Gas zu Flüssiggas in dem Kaltgasmischer 17 kann ein beliebig kalter Gasstrom erzeugt werden.

Selbstverständlich kann die Einstellung der Gas- und Flüssiggasmengen auch über zu- und abschaltbare Bypassleitungen mit unterschiedlichen Durchsatzvolumen und dergleichen erfolgen.

Ausgangsseitig ist der Kaltgasmischer 17 über ein in Leitung 29 angeordnetes und über Steuerleitung 20 ansteuerbares Einstellmittel 27, beispielsweise ein Magnetventil, mit Verteilerelement 28 verbunden. Das Verteilerelement 28, beispielsweise ein Verteilerrohr, erstreckt sich über die gesamte Breite 51 der Leiterplatte 10 und ist als Träger der Düsen 31, 32, 39 ausgebildet, die jeweils über Abzweigleitungen 32, 33, 34 mit dem im Kaltgasmischer erzeugten Kaltgasstrom versorgt werden. Die Düsen 30, 31, 39 sind als Lavaldüsen ausgebildet und weisen Laval-kanäle 35 zur Umformung des Kaltgasstromes in einen kalten Gasstrahl auf. Das Verteilerelement 28 weist Mittel 36 zum Einstellen der Winkellage 37 zwischen Leiterplatte 10 und der Düsen 30, 31, 39 auf. Die Mittel 36, beispielsweise ein Drehgelenk, können selbstverständlich auch den Düsen 30, 31, 39 zugeordnet sein. Bei dieser Ausbildung kann die Winkellage 37 von jeder Düse 30, 31, 39 individuell eingestellt werden. Mehrere dieser Verteilerelemente 28 können in Transportrichtung parallel zueinander angeordnet werden. Dem Verteilerelement und/oder dem Kaltgasmischer 17 sind Temperatursensoren 38, 40 zugeordnet mittels denen die Ist-Temperatur ermittelt und einer Steuerung als Steuersignal zur Verfügung gestellt werden kann. Mit der beispielsweise speicherprogrammierbaren Steuerung 41 werden die Einstellmittel 25, 26, 27 entsprechend des Betriebszustandes der Lötanlage so geschaltet, daß eine diskontinuierliche Betriebsweise möglich ist. Dies ist wegen des oft sehr unregelmäßigen Durchsatzes an Leiterplatten 10 vorteilhaft um den Gasverbrauch zu minimieren. Die diskontinuierliche Steuerung wird in Abhängigkeit von einem Signal erzeugt, das beim Durchlaufen der Leiterplatten 10 in der Lötanlage gebildet wird. Vorteilhaft wird das Signal beim Eintritt der Leiterplatten 10 in Lötanlage gebildet, so daß die im Kaltgasmischer eingestellte Temperatur des Kaltgasstromes in Abhängigkeit von der Vorlaufstrecke der Leiterplatte 10 bis zum Erreichen der aus den Düsen 30, 31, 39 austretenden Gasstrahlen und der mit den Sensoren 38, 40 ermittelten Ist-Temperaturen des Gasstromes eingestellt wird. Die Kaltgasstrahleinrichtung 16 wird mit zwei Steuervarianten mit unterschiedlichen Temperatur-Sollwerten betrieben. In der ersten Betriebsweise wird die Kaltgasstrahleinrichtung 16 aus dem warmen Zustand bei ca. 20 °C in den eigentlichen Betriebszustand kaltgefahren. Bei einer Temperatur > -20 °C bis -30 °C wird die Einrichtung 16 so lange mit einem kalten Gasstrom kalt gefahren bis über die Sensoren 40 und/oder 38 eine Temperatur zwischen -60 °C und -70 °C erfaßt wird. Danach wird ein Gasstrom mit einer Temperatur zwischen -20 °C und -60 °C vorzugsweise zwischen -25 °C bis -30 °C und -35 °C bis -40 °C zur Bildung der aus der Düsen 30, 31, 39 austretenden Gasstrahlen eingestellt.

Der Kaltgasmischer 17 ist in Figur 3 schematisch im Schnitt dargestellt. Der Kaltgasmischer 17 besteht im wesentlichen aus einer Mischkammer 42, die über Gaseingang 43 mit Leitung 23 und über Flüssiggaszuführung 44 mit Leitung 24 verbunden ist. Die Flüssiggaszuführung 44 weist eine Austrittsdüse 45 mit einem runden Austrittskanal 46 auf, vor dem ein Verdüsungselement 47 angeordnet ist. Das Verdüsungselement 47 ist als Prallplatte ausgebildet und mit Abstand vor dem Austrittskanal 46 angeordnet. Die Prallplatte 47 verläuft unter einem Auftreffwinkel 52 > 90° zu dem Austrittskanal 46. In der Mischkammer 42 werden über Flüssiggaszuführung 44 tiefkalt verflüssigtes Gas und über Gaseingang 43 Gas derartig vermischt, daß vor dem Kaltgasausgang 48 die Masse an Flüssigkeit geringer als die des Gases ist. Dazu gelangt das Flüssiggas durch den runden Austrittskanal 46 auf das Verdüsungselement 47, wodurch es feinst in der Mischgaskammer versprüht wird und dort verdampft. Dadurch wird das über Gaseingang zugeführte Gas abgekühlt und über Kaltgasausgang zu dem Verteilerelement 28 geführt.

Versuche haben ergeben, daß ein mit einer Temperatur zwischen -20 °C und -60 °C in den Lavalkanälen 35 geformter Gasstrahl 50 aus einem Inertgas oder einer Inertgasmischung, der unter einem Anblasewinkel 49° von < 45°, vorzugsweise unter einem Anblasewinkel zwischen 30° und 40°, auf die nicht mehr flüssige Lotkugel 14 trifft, eine Fehlanpassung 53 zwischen Lötstoplack 13 und Lotkugel 14 bei gleichzeitiger mechanischer Entfernung der Lotkugeln 14 erzeugt. Durch die Erfindung werden die Lotkugeln 14 bei der Entspannungskontraktion mechanisch durch den Gasstrahl 50 entfernt.

Optional können die Leiterplatten beim Durchgang durch die Lotwelle mittels einer weiteren Flachstrahldüse von unten mit Inertgas beaufschlagt werden. Auf diese Weise kann die Ausbildung kleiner Lotperlen reduziert und das oben beschriebene Verfahren hinsichtlich Zuverlässigkeit weiter gesteigert werden.

## Patentansprüche

1. Verfahren zur mechanischen Beseitigung von Lotkugeln auf der Oberfläche von Leiterplatten unmittelbar nach Durchlaufen der Lotwelle beim Wellenlöten von Leiterplatten in einer Lötanlage
dadurch gekennzeichnet,
daß die Lotkugeln (14) durch mindestens einen auf die Oberfläche gerichteten kalten Gasstrahl (50) mechanisch beseitigt werden.

2. Verfahren nach Anspruch 1,
dadurch gekennzeichnet,
daß die Oberfläche von dem Gasstrahl (50) mit einer Temperatur zwischen -20 °C und -60 °C beaufschlagt wird.

3. Verfahren nach Anspruch 1 oder 2,
dadurch gekennzeichnet,
daß die Oberfläche nach dem Erstarren der Lotkugeln (14) von dem Gasstrahl (50) beaufschlagt wird.

4. Verfahren nach einem der Ansprüche 1 bis 3,
dadurch gekennzeichnet,
daß der Gasstrahl (50) unter einem Anblasewinkel (49) kleiner 45°, vorzugsweise unter einem Anblasewinkel zwischen 30° und 40°, die Oberfläche beaufschlagt.

5. Verfahren nach einem der Ansprüche 1 bis 4,
dadurch gekennzeichnet,
daß mindestens eine Seite der Oberfläche über die gesamte Breite (51) der Leiterplatte (10) mit mehreren kalten Gasstrahlen (50) beaufschlagt wird, die durch eine Vereinzelung aus einem kalten Gasstom jeweils erzeugt werden

6. Verfahren nach einem der Ansprüche 1 bis 5,
dadurch gekennzeichnet
daß der kalte Gasstrom aus einem Inertgas, insbesondere Stickstoff, Argon, Kohlendioxid oder Gasmischungen daraus, gebildet wird.

7. Verfahren nach einem der Ansprüche 1 bis 6,
dadurch gekennzeichnet,
daß der kalte Gasstrom aus der gasförmigen und flüssigen Phase des eingesetzten Gases oder Gasgemisches gebildet wird.

8. Verfahren nach einem der Ansprüche 1 bis 7,
dadurch gekennzeichnet,
daß die kalten Gasstrahlen (50) in Düsen (30, 31, 39) gebildet und mit einem hohen Abblasedruck gegen die Oberfläche gerichtet werden.

9. Verfahren nach einem der Ansprüche 1 bis 8,
dadurch gekennzeichnet,
daß die Gasstrahlen (50) in Lavalkanälen (35) der Düsen (30, 31, 39) geformt werden.

10. Verfahren nach einem der Ansprüche 1 bis 9,
dadurch gekennzeichnet,
daß der kalte Gasstrom diskontinuierlich in Abhänigkeit von einem Signal erzeugt wird, das beim Durchlaufen der Leiterplatten (10) in der Lötanlage gebildet wird.

11. Verfahren nach einem der Ansprüche 1 bis 10,
dadurch gekennzeichnet,
daß die Temperatur des kalten Gasstroms in Abhängigkeit von der Vorlaufstrecke der Leiterplatte (10) bis zum Erreichen der Gasstrahlen (50) und/oder der Ist-Temperatur (38, 40) des Gasstroms eingestellt wird.

12. Vorrichtung zur mechanischen Beseitigung von Lotkugeln auf der Oberfläche von Leiterplatten unmittelbar nach Durchlaufen der Lotwelle beim Wellenlöten von Leiterplatten in einer Lötanlage,
gekennzeichnet durch,
einen Kaltgasmischer (17) der eingangseitig über zwei Leitungen (23, 24) mit mindestens einem Tank (21) für tiefkalt verflüssigte Gase oder Gasgemische und ausgangsseitig mit mindestens einer auf die Oberfläche der Leiterplatten (10) gerichteten Düse (30, 31, 39) verbunden ist.

13. Vorrichtung nach Anspruch 12,
dadurch gekennzeichnet,
daß die Düse (30, 31, 39) als Lavaldüse ausgebildet ist.

14. Vorrichtung nach Anspruch 12 oder 13,
dadurch gekennzeichnet,
daß in einer Leitung (23) ein Verdampfer (22) angeordnet ist.

15. Vorrichtung nach einem der Ansprüche 12 bis 15,
dadurch gekennzeichnet,
daß in den Leitungen (23, 24) ansteuerbare Einstellmittel (25, 26) angeordnet sind.

16. Vorrichtung nach einem der Ansprüche 12 bis 15,
dadurch gekennzeichnet,
daß zwischen den Düsen (30, 31, 39) und dem Kaltgasmischer (17) ein Verteilerelement (28) mit vorgeschaltetem Einstellmittel (27) angeordnet ist, das als Düsenträger ausgebildet ist.

17. Vorrichtung nach einem der Ansprüche 12 bis 16,
dadurch gekennzeichnet,
daß das Verteilerelement (28) und/oder die Düsen (30, 31, 39) über Mittel (36) in ihrer Winkellage (37) zur Oberfläche einstellbar sind.

18. Vorrichtung nach einem der Ansprüche 1 bis 17,
dadurch gekennzeichnet,
daß der Kaltgasmischer (17) aus einer Mischkammer (45) mit einem Gaseingang (43) und einem Kaltgasausgang (48) und einer in die Mischkammer (45) geführte Flüssiggaszuführung (44) besteht, die eine Austrittsdüse (45) mit einem Austrittskanal (46) aufweist, dem ein Verdüsungselement (47) zugeordnet ist.

19. Vorrichtung nach Anspruch 18,
dadurch gekennzeichnet,
daß der Austrittskanal (46) rund ist und das Verdüsungselement (47) als Prallplatte ausgebildet ist und mit Abstand vor dem Austrittskanal (46) angeordnet ist.

20. Vorrichtung nach Anspruch 18 oder 19,
dadurch gekennzeichnet,
daß die Prallplatte unter einem Auftreffwinkel (52) größer 90° zu dem Austrittskanal (46) verläuft.
